# DEMANDE DE BREVET EUROPEEN

(11) **EP 1 918 416 A1**
(43) Date de publication de la demande: **07.05.2008**
(21) Numéro de dépôt: 07119721.4
(22) Date de dépôt: 31.10.2007
(51) Int. Cl.: C23C 16/40

(54) **Procede de depot de couche mince et produit obtenu**

(30) Priorité: 02.11.2006 FR 0654699
(71) Demandeur: Lapeyre, 92400 Courbevoie (FR)
(72) Inventeur: Besson, Sophie, 75005 Paris (FR); Duran, Maxime, 11570 Cavanac (FR); Garre, Emmanuel, 78110 Le Vésinet (FR); Gentilhomme, Carole, 93600 Aulnay sous Bois (FR); Viasnoff, Emilie, Sèvres 92310 (FR); Victor, Corinne, 95320 Saint-Leu la Forêt (FR); Gay, Thierry, 71250 Cluny (FR)
(74) Mandataire: Teyssedre, Laurent

(57) **Abrégé**

L'invention a pour objet un procédé d'obtention d'un matériau comprenant un substrat dont au moins une partie de la surface d'au moins une de ses faces est à base de composés organiques, ledit procédé étant mis en oeuvre à pression atmosphérique et sans chauffage de la totalité dudit substrat, ledit procédé comprenant en outre les étapes suivantes :
- on crée à proximité immédiate dudit substrat une zone contenant des espèces actives d'un plasma non thermique,
- on injecte dans ladite zone au moins un précurseur d'un élément chimique de manière à déposer sur au moins une face dudit substrat dont au moins une partie de la surface est à base de composés organiques une première couche mince susceptible de protéger ledit substrat contre des réactions d'oxydation, notamment radicalaire.

L'invention a également pour objet le matériau susceptible d'être obtenu selon ce procédé.

## Description

L'invention se rapporte au domaine des matériaux présentant une fonctionnalité auto-nettoyante et/ou de facilité de nettoyage et/ou antisalissure. Elle concerne notamment des matériaux architecturaux comprenant un substrat au moins en partie de nature organique, comme le PVC, le polyéthylène, le polypropylène, le bois peint ou l'aluminium peint, revêtu d'au moins une couche mince susceptible de protéger ledit substrat contre des réactions d'oxydation radicalaire ainsi que le procédé d'obtention de tels matériaux.

Les matériaux, notamment architecturaux, sont généralement soumis à l'empoussièrement, à la pollution atmosphérique et voient leur aspect de surface se dégrader au fil du temps. Pour éviter des nettoyages trop fréquents et coûteux, des matériaux possédant des fonctionnalités auto-nettoyantes et/ou de facilité de nettoyage et/ou antisalissure ont été développés. On entend par propriété auto-nettoyante la faculté pour un matériau sali de dégrader et/ou éliminer les salissures, tant organiques que minérales, déposées à sa surface. On entend par propriété de facilité de nettoyage la faculté pour un matériau sali d'être facilement nettoyé, par exemple par une simple aspersion d'eau, sans traitements mécaniques ou chimiques. On entend par propriété antisalissure la faculté pour un matériau de rester propre sur de longues durées (plusieurs mois ou années) dans un environnement standard.

Un certain nombre de ces matériaux utilisent les propriétés photocatalytiques et de superhydrophilie photo-induite de l'oxyde de titane (TiO₂) en étant revêtus par une ou plusieurs couches comprenant cet oxyde. Ce dernier, notamment quand il est cristallisé sous la forme anatase, a la particularité, lorsqu'il est soumis à un rayonnement ultraviolet, notamment la lumière solaire, de catalyser les réactions de dégradation radicalaire de salissures organiques et de devenir superhydrophile (ces deux propriétés étant indépendantes). Cette dernière propriété empêche notamment la formation de gouttelettes d'eau qui en séchant déposent des salissures minérales, et favorise le nappage de la surface par l'eau de pluie et donc l'évacuation des salissures. Le matériau ainsi obtenu présente donc la particularité de s'auto-nettoyer sous l'action de la lumière du soleil et de l'eau de pluie. La demande EP-A-0 850 204 décrit ainsi ce type d'application dans le cas de vitrages.

Dans le cas des matériaux architecturaux dont la surface comprend des composés organiques, par exemple le polychlorure de vinyle (PVC), le polyéthylène, le polypropylène, le bois peint, ou l'aluminium peint, il n'est pas possible de déposer un revêtement photocatalytique directement sur le matériau, car le revêtement photocatalytique dégraderait ces composés organiques par réactions d'oxydation radicalaire. Des couches barrières minérales protégeant ces matériaux ont donc été proposées. La demande EP-A-1 498 176 décrit par exemple des couches barrières à base de SiO₂, ZrO₂ etc., et d'épaisseur 30 micromètres, qui protègent les profilés de fenêtres en PVC de l'action photocatalytique d'une couche à base de TiO₂. Ces couches barrières sont obtenues à basse température par un procédé de type sol-gel, dans lequel des précurseurs en solution dans un solvant (sol) sont déposés sur le substrat et vont gélifier en formant un revêtement solide à la surface dudit substrat.

Il est apparu aux inventeurs que les couches barrières ainsi obtenues ne présentaient pas une adhésion satisfaisante avec les couches susceptibles d'être déposées par-dessus dans le cas d'un substrat dont au moins la surface est à base de composés organiques, car de tels substrats présentent au moins au niveau de leur surface un coefficient de dilatation thermique élevé, et en particulier beaucoup plus élevé que celui de matériaux inorganiques utilisables comme couches barrières.

Lorsque de tels substrats sont employés, la couche barrière ne peut être recuite car la forte différence de coefficient de dilatation entre le substrat et la couche barrière minérale engendrerait lors du refroidissement des contraintes mécaniques, des craquelures et donc une mauvaise adhésion entre le substrat et la couche barrière. Or, il semblerait, sans vouloir être lié par une quelconque théorie scientifique, que les couches barrières obtenues par un procédé de type sol-gel et non (ou insuffisamment) recuites contiennent une certaine quantité de solvant préjudiciable à une bonne adhésion avec les couches qui les surmontent.

L'invention a donc pour but d'obvier à ces inconvénients en proposant un procédé de dépôt permettant d'obtenir des couches barrières présentant une adhésion améliorée avec les couches susceptibles d'être déposées au-dessus d'elles.

A cet effet, l'invention a pour objet un procédé d'obtention d'un matériau comprenant un substrat dont au moins une partie de la surface d'au moins une de ses faces est à base de composés organiques, ledit procédé étant mis en oeuvre à pression atmosphérique et sans chauffage de la totalité dudit substrat, ledit procédé comprenant en outre les étapes suivantes :
- on crée à proximité immédiate dudit substrat une zone contenant des espèces actives d'un plasma non thermique,
- on injecte dans ladite zone au moins un précurseur d'un élément chimique de manière à déposer sur au moins une face dudit substrat dont au moins une partie de la surface est à base de composés organiques une première couche mince susceptible de protéger ledit substrat contre des réactions d'oxydation, notamment radicalaire.

Le substrat est de préférence choisi parmi les substrats en polychlorure de vinyle (PVC), en polyéthylène (PE), en polypropylène (PP), en bois peint ou en aluminium peint. Ces matériaux couramment employés dans le domaine architectural, notamment pour la réalisation de fenêtres, portails ou bardages, présentent en effet un fort coefficient de dilatation, soit intrinsèquement, soit au niveau de leur surface peinte (et étant par conséquent à base de composés organiques). Le PVC présente l'inconvénient de se déformer à des températures de plus de 60°C et possède un coefficient de dilatation thermique de 40 à 80.10⁻⁶/°C. L'aluminium présente quant à lui un coefficient de dilatation thermique de 23.10⁻⁶/°C. Par comparaison, l'oxyde de silicium, couramment employé comme couche barrière possède un coefficient de dilatation thermique de l'ordre de seulement 3.10⁻⁶/°C.

La mise en oeuvre du procédé selon l'invention n'implique pas de chauffage de la totalité du substrat. On entend par cela le fait qu'on ne dispose pas de moyens de chauffage permettant de porter le substrat dans son ensemble à une température supérieure à 50°C, de préférence 40°C. L'interaction des espèces actives du plasma avec la surface du substrat peut en revanche échauffer localement ladite surface sur une faible profondeur, typiquement de l'ordre de 0,1 mm ou moins, sans toutefois que la température du substrat dans son ensemble ne dépasse la température ambiante (de l'ordre de 15 à 40°C, voire 50°C).

La mise en oeuvre du procédé selon l'invention se fait à pression atmosphérique. Il faut entendre par cela le fait que la pression qui environne le substrat est de l'ordre de 1 atmosphère (100 000 Pa). Le procédé selon l'invention présente donc l'avantage de ne pas nécessiter d'installation sous vide.

Un plasma est un gaz ionisé généralement obtenu en soumettant un gaz dit « plasmagène » à une excitation telle qu'un fort champ électrique continu ou alternatif ou une excitation thermique ou lumineuse. Sous l'action de cette excitation, des électrons sont arrachés aux atomes du gaz et les charges ainsi créées migrent vers les électrodes de charge opposée. Ces charges excitent ensuite d'autres atomes du gaz par collision, créant par effet d'avalanche une décharge homogène ou microfilamentaire ou encore un arc.

Les plasmas peuvent être « chauds » (le gaz est alors entièrement ionisé et la température du plasma est de l'ordre de 10⁶°C), ou « thermiques » (le gaz est presque entièrement ionisé et la température du plasma est de l'ordre de 10⁴°C, cas par exemple des arcs électriques). Selon l'invention le plasma est « non thermique » ou « froid » : il s'agit d'un plasma hors équilibre thermique dans lequel le gaz est très faiblement ionisé (taux d'ionisation de l'ordre de 10⁻² à 10⁻⁶), la température des ions et des espèces neutres étant de quelques dizaines ou centaines de degrés Celsius et celle des électrons de plusieurs milliers de degrés. Compte tenu de la masse négligeable des électrons, le plasma est globalement froid.

Les plasmas contiennent beaucoup d'espèces actives, c'est-à-dire susceptibles d'interagir avec la matière, dont les ions, les électrons ou les radicaux libres, ces derniers ayant la plus grande durée de vie dans le cas d'une mise en oeuvre du plasma à pression atmosphérique. L'interaction des espèces actives d'un plasma avec la matière est industriellement utilisée pour activer, décaper ou graver des surfaces, ou encore pour déposer des couches minces. Un exemple de procédé de dépôt utilisant ces interactions est le dépôt chimique en phase vapeur assisté par plasma (plasma-enhanced chemical vapour déposition ou PECVD) dans lequel on crée à proximité immédiate d'un substrat une zone contenant des espèces actives d'un plasma non thermique et l'on injecte dans ladite zone au moins un précurseur gazeux. Le procédé PECVD peut être mis en oeuvre sous vide ou à pression atmosphérique (il est alors noté APPECVD), ce dernier procédé étant utilisable dans le procédé selon l'invention.

Les espèces actives du plasma peuvent être générées à proximité immédiate du substrat, par exemple en positionnant ledit substrat entre deux électrodes (on parle alors de plasma « in situ »). Les espèces actives du plasma peuvent également être générées dans une enceinte à l'aide d'un champ électrique puis soufflées à l'extérieur de ladite enceinte en direction du substrat. On parle dans ce cas de plasma déporté, qui présente l'avantage de soumettre le substrat à des températures plus basses, la densité du plasma en espèces actives étant toutefois plus faible que dans le cas d'un plasma in situ. Le plasma déporté est également plus aisément applicable lorsque l'épaisseur du substrat à revêtir est importante.

Le plasma peut être de basse fréquence (moins de 100 kHz). Des plasmas dont la fréquence est située dans le domaine des micro-ondes (de plus de 100 kHz) ou des radio-fréquences sont également utilisables. La puissance du plasma est de préférence inférieure ou égale à 100 W/cm² et/ou supérieure ou égale à 1 µW/cm², voire 1 mW/cm².

Le gaz plasmagène est de préférence à base de gaz inerte tel que l'hélium, le néon, l'argon ou l'azote, ou d'un mélange de gaz inertes. L'azote est particulièrement préféré en raison de son faible coût.

Le gaz plasmagène peut alors également contenir, mais de manière minoritaire, un gaz oxydant tel que l'oxygène ou le protoxyde d'azote. L'air peut ainsi être utilisé comme gaz plasmagène. Les oxydants permettent en effet de faciliter les réactions de décomposition des précurseurs ou les réactions d'activation.

Alternativement, le gaz plasmagène peut être à base d'un gaz oxydant tel que l'oxygène.

Le ou chaque précurseur employé pour déposer la première couche mince est de préférence sous forme gazeuse (il s'agit alors d'un procédé de type APPECVD) ou liquide. Dans ce dernier cas, le précurseur est avantageusement sous forme de microgouttelettes en suspension dans le gaz plasmagène. Ces microgouttelettes présentent de préférence un diamètre inférieur ou égal à 1 mm, notamment inférieur ou égal à 0,1 mm.

Le ou chaque précurseur est injecté de préférence par les techniques connues de l'homme du métier, par exemple en employant une buse classiquement utilisée dans les procédés de dépôt chimique en phase vapeur (CVD).

La première couche mince comprend de préférence du silicium et de l'oxygène.

Pour des raisons de simplicité et parce que la silice est efficace pour protéger contre les réactions d'oxydation radicalaire, la première couche mince est avantageusement à base d'oxyde de silicium (SiO₂ ou SiOₓ si l'oxyde n'est pas parfaitement stoechiométrique), voire constituée de SiO₂ (ou SiOₓ). D'autres matériaux inorganiques sont toutefois intéressants, tels l'oxyde de zirconium ou l'oxyde d'aluminium, seuls ou en mélange avec l'oxyde de silicium.

Selon un mode de réalisation alternatif, la première couche mince peut être une couche hybride organique/inorganique comprenant du silicium, de l'oxygène et des espèces carbonées liées de manière covalente au silicium. Dans ce cas, il est préférable que la teneur en espèces carbonées décroisse linéairement dans l'épaisseur de ladite couche mince depuis la zone la plus proche du substrat jusqu'à la surface du matériau. Plus déformables ou élastiques que les couches purement inorganiques, les couches hybrides présentent l'avantage de mieux s'adapter aux variations dimensionnelles du substrat et donc de limiter la génération de contraintes mécaniques en leur sein.

Le gradient de teneur en carbone décroissant dans l'épaisseur de la couche en partant de l'interface avec le substrat est avantageux car les espèces carbonées contenues en surface de la couche sont susceptibles d'être dégradées par le revêtement photocatalytique éventuellement déposé au-dessus de la première couche, entraînant une délamination et par conséquent une mauvaise adhésion.

De telles couches minces hybrides peuvent être obtenues par exemple en utilisant un précurseur de silicium contenant au moins une chaîne carbonée liée de manière covalente au silicium par une liaison SiC, par exemple le trimethyl-trimethylsilyloxy-silane (HDMSO). Elles peuvent également être obtenues par l'utilisation de précurseurs de silicium comprenant des liaisons Si-O-C, par exemple le tétraéthoxysilane (TEOS) ou le tétraméthoxysilane (TMOS), ou de manière générale tout type d'alkoxysilanes, seuls ou en mélange. L'interaction des précurseurs avec les espèces actives du plasma non thermique ne conduit en effet pas nécessairement à une fragmentation totale des précurseurs avec élimination des espèces carbonées. Certains groupements alkoxy peuvent ainsi rester liés à l'atome de silicium dans la couche, en particulier lorsque la puissance du plasma est faible et/ou lorsque la teneur en gaz oxydants dans le gaz plasmagène est faible. Le gradient de teneur en carbone dans la couche peut être obtenu le cas échéant en modulant au cours du dépôt la puissance du plasma et/ou la teneur en gaz oxydants dans le gaz plasmagène et/ou le débit de précurseur.

L'épaisseur de la première couche mince est de préférence comprise entre 1 nm et 1 micromètre, notamment entre 1 et 100 nm, voire entre 5 et 50 nm ou entre 10 et 20 nm. De telles épaisseurs, très minces, se sont révélées suffisantes pour obtenir une bonne protection du substrat contre les réactions d'oxydation radicalaire, probablement du fait de la densité des couches obtenues par le procédé selon l'invention. Compte tenu de leur très faible épaisseur, les couches sont parfaitement transparentes et non colorées.

Le procédé selon l'invention comprend de préférence une étape dans laquelle on dépose sur la première couche mince une seconde couche mince à propriété photocatalytique, laquelle comprend avantageusement de l'oxyde de titane au moins partiellement cristallisé sous forme anatase.

L'oxyde de titane peut être présent dans cette seconde couche mince sous forme de nanoparticules réparties dans un liant inorganique, de préférence un liant à base d'oxyde de silicium, notamment obtenu par un procédé de type sol-gel. L'oxyde de silicium du liant peut être pur ou mélangé avec d'autres oxydes tels que les oxydes d'aluminium et de zirconium afin d'améliorer la résistance hydrolytique de la couche.

Les inventeurs ont mis en évidence que les couches obtenues selon ce mode de réalisation (par le procédé sol-gel) présentent l'avantage d'être moins sensibles aux variations dimensionnelles du substrat et de la sous-couche et par conséquent de mieux résister aux dilatations thermiques.

Les nanoparticules présentent de préférence un diamètre compris entre 5 et 500 nm, de préférence entre 10 et 50 nm.

La seconde couche mince peut ainsi être obtenue par un procédé de type sol-gel, c'est-à-dire par hydrolyse et condensation d'un sol comprenant au moins un précurseur de SiO₂ (par exemple le tétraéthoxysilane ou TEOS) et des nanoparticules d'oxyde de titane. La couche obtenue peut être peu poreuse, mais sa porosité peut également être développée en ajoutant au sol des agents tensioactifs structurants de manière à créer des mésopores, comme enseigné par la demande WO 03/087002. Dans le cas présent, l'élimination des agents structurants peut se faire à basse température par irradiation au moyen de rayonnement ultraviolet. Les couches comprenant un liant poreux, et en particulier mésoporeux, présentent l'avantage d'être beaucoup plus actives du point de vue de la photocatalyse mais sont en même temps plus fragiles mécaniquement et présentent une plus faible résistance hydrolytique. Pour des applications en extérieur, lorsque le matériau est soumis au rayonnement solaire, les liants peu poreux, donc obtenus sans ajout d'agents structurants, se sont révélés suffisants en terme d'activité photocatalytique tout en présentant une bonne résistance hydrolytique. La quantité respective d'éléments titane et silicium dans la seconde couche peut être aisément régulée. Une couche contenant beaucoup d'oxyde de titane et peu de liant d'oxyde de silicium présente de fortes activités photocatalytiques mais également une faible résistance hydrolytique. De ce fait, le rapport molaire Ti/Si dans la seconde couche est de préférence compris entre 0,01 et 1, notamment entre 0,05 et 0,8, voire entre 0,1 et 0,5.

Une couche caractérisée par un rapport molaire Ti/Si entre 0,01, notamment 0,1 et 0,5 et un liant non mésoporeux est préférée lorsque le matériau doit être exposé en extérieur, dans la mesure où ces conditions permettent d'obtenir la meilleure résistance hydrolytique.

Un procédé sol-gel typique consiste à hydrolyser un précurseur de silice (notamment le TEOS) dans un mélange d'eau acidifiée et d'alcool. La condensation a lieu à pH acide (typiquement entre 1 et 2).

Un procédé de type sol-gel préféré consiste toutefois à solubiliser un précurseur de silice (notamment le TEOS susmentionné) en milieu acide (notamment en milieu aqueux et acide, à pH entre 1 et 3), puis, pendant l'étape de condensation, à rendre le milieu basique (pH typiquement entre 7 et 9) puis éventuellement à nouveau acide. De cette manière une microstructure particulière est obtenue, qui confère une activité photocatalytique plus élevée pour une même concentration en TiO₂, ainsi qu'une durabilité plus forte. De bonnes propriétés photocatalytiques peuvent ainsi être obtenues pour des rapports molaires Ti/Si aussi bas que 0,01, voire encore moins.

La seconde couche mince à propriété photocatalytique peut alternativement être obtenue en injectant dans la zone contenant les espèces actives du plasma non thermique au moins un précurseur de titane ou des nanoparticules d'oxyde de titane.

Ce procédé présente l'avantage par rapport au procédé sol-gel précédemment décrit de pouvoir être réalisé immédiatement après le dépôt de la première couche mince susceptible de protéger le substrat contre des réactions d'oxydation radicalaire en utilisant le même dispositif. Le précurseur de titane peut être gazeux ou liquide, dans ce dernier cas de préférence sous forme de microgouttelettes en suspension dans le gaz plasmagène. Il peut s'agit d'halogénures de titane ou d'alcoolates de titane, comme par exemple le tétrachlorure de titane (TiCl₄) ou le tétraisopropylate de titane (noté TiPT).

L'oxyde de titane peut également être avantageusement ajouté à la seconde couche en injectant dans la zone contenant les espèces actives du plasma des nanoparticules d'oxyde de titane, de préférence cristallisé sous forme anatase. De cette manière, l'oxyde de titane est déjà cristallisé sous sa forme la plus active sur le plan de la photocatalyse. Dans le cadre de ce mode de réalisation particulier, les deux étapes de dépôt des première et seconde couches peuvent même être réunies en une seule étape dans laquelle on injecte dans la zone contenant les espèces actives du plasma au moins un précurseur de silicium et d'oxygène et un précurseur de titane (ou des nanoparticules d'oxyde de titane), en modulant les teneurs respectives en ces deux éléments au cours du dépôt. Au commencement du dépôt de la couche unique, seul le précurseur de silicium et d'oxygène (par exemple le TEOS) est injecté, donnant naissance à une couche composée de silice (SiO₂). Une quantité croissante de nanoparticules d'oxyde de titane est ensuite ajoutée, de manière à créer un gradient de teneur en titane croissant dans l'épaisseur de la couche. On évite de cette manière de mettre de l'oxyde de titane en contact avec le substrat, tout en en maximisant la quantité d'oxyde de titane présent en surface, donc utile pour la photocatalyse.

La surface du substrat ou du matériau est avantageusement soumise à l'action d'espèces actives du plasma non thermique avant le dépôt de la première couche mince et/ou avant le dépôt de la seconde couche mince et/ou après le dépôt de la seconde couche mince.

L'activation du substrat avant tout dépôt par les espèces actives du plasma permet de créer des groupements hydroxyles en surface dudit substrat, améliorant l'adhésion de la première couche au substrat.

Il a été observé que le même type d'activation après le dépôt de la première couche mince permettait de rendre la surface de cette couche plus hydrophile et améliorait encore l'adhésion entre la première et la seconde couche. Dans le cas d'une première couche en silice, des angles de contact à l'eau inférieurs à 20°, voire 10° peuvent ainsi être obtenus grâce à cette étape d'activation.

Une telle activation après le dépôt de la seconde couche permet quant à elle de densifier ladite deuxième couche (notamment quand elle a été obtenue par un procédé de type sol-gel), augmentant sa résistance mécanique et hydrolytique.

Le gaz plasmagène utilisé pour ces différentes étapes d'activation n'est pas nécessairement celui employé lors des étapes de dépôt des couches. En particulier, l'utilisation d'oxygène (O₂) comme gaz plasmagène est préférée pour au moins une des étapes d'activation, alors que l'utilisation d'azote (N₂) s'est révélée particulièrement intéressante pour réaliser le dépôt des couches.

L'invention a également pour objet un matériau susceptible d'être obtenu par le procédé selon l'invention, et en particulier un élément architectural tel que fenêtre, volet, mur, bardage, tuile (par exemple en polypropylène), entourage de piscine, aménagement de jardin ou portail comprenant un tel matériau.

L'invention a encore pour objet l'utilisation du matériau selon l'invention en tant que matériau auto-nettoyant et/ou susceptible de ne pas se salir (propriétés antisalissure) et/ou d'être aisément nettoyé. Ces différents effets techniques sont en effet obtenus, cumulativement ou alternativement par les couches déposées selon l'invention, grâce à l'hydrophilie photo-induite de l'oxyde de titane ou l'hydrophilie de la couche barrière, en particulier lorsqu'il s'agit d'une couche à base d'oxyde de silicium ou en contenant.

En particulier, comme montré ci-après par les exemples de réalisation, il s'est révélé que le revêtement selon l'invention d'une couche à base d'oxyde de silicium permettait de conférer de très nettes propriétés antisalissure (faculté de ne pas se salir) au PVC ou à l'aluminium peint. Ainsi, la couche, traditionnellement utilisée comme couche barrière lorsque des couches photocatalytiques sont déposées au-dessus d'elles, permet, en l'absence de telles couches photocatalytiques, de jouer un tout autre rôle.

L'invention a donc aussi pour objet l'utilisation d'une couche à base d'oxyde de silicium (en particulier obtenue selon l'invention et telle que décrite ci-avant) pour conférer des propriétés antisalissure à des éléments architecturaux (tels que fenêtre, volet, mur, bardage, tuile, entourage de piscine, aménagement de jardin ou portail) à base de PVC, de polyéthylène, de polypropylène, de bois peint ou d'aluminium peint. Tout ce qui précède concernant les modes de réalisation particuliers de la couche à base d'oxyde de silicium peut être combiné avec cette nouvelle utilisation.

L'invention sera mieux comprise à la lumière des exemples non limitatifs suivants.

### EXEMPLE 1

On place un substrat en PVC de couleur blanche sous une source de plasma déporté afin de procéder au dépôt d'une couche de silice. Le plasma, d'une puissance de 1350W, est créé dans l'enceinte de la source à l'aide d'un gaz plasmagène qui est un mélange d'azote (débit de 200 litres standard par minute) et d'oxygène (0,5 litre standard par minute) puis soufflé à l'extérieur de l'enceinte via une fente de 12 cm de long et 2 mm de large en direction du substrat qui défile sous la source. On crée ainsi au dessus et à proximité immédiate du substrat une zone contenant des espèces actives. Dans cette zone est injecté à l'aide d'une buse du tétraéthoxysilane gazeux à 80°C mélangé à de l'azote (débit 2 litres standard par minute). Ce précurseur de silice est dégradé sous l'action des espèces actives et se dépose sous forme de couche mince de silice (SiO₂) d'environ 20nm d'épaisseur.

On dépose ensuite au-dessus de cette première couche barrière une seconde couche à base de nanoparticules de TiO₂ dispersées dans un liant de silice. Pour cela, on mélange du tétraéthoxysilane (TEOS), de l'éthanol et de l'eau acidifiée à un pH de 1,25 dans un rapport molaire 1 :5 :3,8. L'ensemble est chauffé pendant 1 heure à 60°C puis dilué dans un volume double d'éthanol. Des nanoparticules de TiO₂ sont ensuite ajoutées de manière à obtenir un rapport molaire Ti/Si proche de 0,5.

Le sol ainsi obtenu est déposé sur le substrat de PVC déjà revêtu de sa première couche par une technique de dip coating (trempage) de manière à obtenir une seconde couche présentant une activité photocatalytique. Les techniques de spray-coating (revêtement par pulvérisation) ou de roll-coating (enduction au rouleau) sont également utilisables moyennant un ajustement du choix des solvants et de la concentration du sol, ajustement bien connu de l'homme du métier.

La mesure de l'adhésion de la seconde couche est réalisée à l'aide d'un ruban adhésif conformément à la norme NF ISO 9211-4 et aucun enlèvement de couches n'est détecté.

Le matériau obtenu présente un caractère de superhydrophilie après 24 heures d'irradiation à l'aide d'un rayonnement ultraviolet de type UVA. Après 12 mois d'exposition en plein air (exposition nord), le matériau selon l'invention ne présente que très peu de salissures à sa surface, tandis qu'un échantillon de PVC non traité (revêtu d'aucune couche) est extrêmement sale. En outre, les rares salissures déposées sur le matériau obtenu selon l'invention sont éliminées par simple aspersion d'eau, ce qui n'est pas le cas des salissures déposées sur le PVC non traité.

### EXEMPLE 2 (COMPARATIF)

Cet exemple comparatif est similaire à l'exemple 1, à la seule différence près que la couche barrière en SiO₂ est obtenue par un procédé de type sol-gel à l'aide de TEOS et non par un procédé de type APPECVD.

L'adhésion de la seconde couche à la couche barrière est mauvaise puisque le test d'adhésion selon la norme NF ISO 9211-4 conduit à la délamination de la seconde couche. On observe même un démouillage de la couche présentant une activité photocatalytique au moment de son dépôt sur la couche barrière.

Les couches barrières obtenues par le procédé selon l'invention présentent par conséquent une adhésion renforcée avec la seconde couche par rapport aux couches barrières obtenues par les procédés de l'art antérieur.

### EXEMPLE 3

Cet exemple se distingue de l'exemple 1 en ce que la seconde couche n'est pas déposée. Le matériau est donc constitué de PVC revêtu par une couche de SiO₂ obtenue conformément à l'invention.

Après 12 mois d'exposition en extérieur, la surface du matériau est nettement moins sale que la surface d'un PVC non traité. Les salissures qui s'y sont déposées sont en outre aisément éliminées par jet d'eau, contrairement aux salissures s'étant déposées sur le PVC non traité. Le matériau obtenu selon l'invention présente donc l'avantage de moins se salir et d'être facilement nettoyé. Ces avantages sont toutefois moins prononcés que dans le cas de l'exemple 1, où l'on dépose en outre une couche photocatalytique.

La résistance hydrolytique de la couche obtenue est excellente.

### EXEMPLE 4 (COMPARATIF)

Cet exemple se distingue de l'exemple 1 en ce que la première couche barrière n'est pas déposée. La couche photocatalytique à base de TiO₂ est donc en contact direct avec le PVC.

La durabilité des couches obtenues est très faible, et en particulier les couches obtenues se détachent facilement du substrat PVC après quelques semaines d'exposition, ce qui est dû à l'attaque du PVC par les réactions d'oxydation radicalaire catalysées par l'oxyde de titane.

### EXEMPLES 5 et 6

Les exemples 5 et 6 se distinguent de l'exemple 1 en ce que le liant de la seconde couche est du type mésoporeux et par le rapport Ti/Si.

Pour obtenir un liant mésoporeux, on mélange du tétraéthoxysilane (TEOS), de l'éthanol et de l'eau acidifiée à un pH de 1,25 dans un rapport molaire 1 :5 :3,8. L'ensemble est chauffé pendant 1 heure à 60°C puis dilué dans un volume double d'éthanol contenant un agent structurant qui est un copolymère bloc polyoxyéthylène-polyoxypropylène commercialisé par la société BASF sous la marque enregistrée Pluronic PE6800 (masse molaire 8000), en proportions telles que le rapport molaire PE6800/Si est de 0,01. Des nanoparticules de TiO₂ sont ensuite ajoutées de manière à obtenir un rapport molaire Ti/Si de 1 (exemple 5) et 0,1 (exemple 6). Le dépôt proprement dit est ensuite réalisé comme dans le cas de l'exemple 1 et l'agent structurant est éliminé sous irradiation aux rayonnements UV grâce à l'action photocatalytique de l'oxyde de titane.

L'adhésion entre la couche barrière et la deuxième couche est satisfaisante.

L'activité photocatalytique de la couche la moins chargée en TiO₂ (exemple 6) est similaire à celle obtenue dans le cas de l'exemple 1, malgré une quantité de TiO₂ cinq fois moindre, ce qui démontre l'influence du caractère poreux du liant. L'activité photocatalytique du matériau selon l'exemple 5 est quant à elle beaucoup plus élevée.

La résistance hydrolytique des couches après vieillissement accéléré selon la norme ASTM G155 est meilleure dans le cas de l'exemple 6 que dans le cas de l'exemple 5, mais n'atteint pas celle obtenue par l'exemple 1 (cas d'un liant non poreux).

Après exposition de 12 mois en plein air, les matériaux selon les exemples 5 et 6 sont parfaitement propres.

### EXEMPLE 7

On place un substrat en aluminium peint sous une source de plasma déporté afin de procéder au dépôt d'une couche de silice. Le plasma, d'une puissance de 1350W ou de 1500W selon les échantillons, est créé dans l'enceinte de la source à l'aide d'un gaz plasmagène qui est un mélange d'azote (débit de 200 litres standard par minute) et d'oxygène (0,5 litre standard par minute) puis soufflé à l'extérieur de l'enceinte via une fente de 12 cm de long et 2 mm de large en direction du substrat qui défile sous la source. On crée ainsi au dessus et à proximité immédiate du substrat une zone contenant des espèces actives. Dans cette zone est injecté à l'aide d'une buse du tétraéthoxysilane gazeux à 80°C mélangé à de l'azote (débit 2 litres standard par minute). Ce précurseur de silice est dégradé sous l'action des espèces actives et se dépose sous forme de couche mince de silice (SiO₂) d'environ 20nm d'épaisseur.

Pour certains échantillons, on dépose ensuite au-dessus de cette première couche barrière une seconde couche à base de nanoparticules de TiO₂ dispersées dans un liant de silice. Pour cela, on mélange 3mL de tétraéthoxysilane (TEOS) avec 23 mL d'une solution aqueuse de HCl 0,01 N. Après chauffage sous agitation à 60°C pendant 1 heure, le milieu est rendu basique par ajout de 2,03 mL d'une solution aqueuse d'ammoniac 1 N. Après chauffage sous agitation à 60°C pendant 1 heure, le milieu, tout en étant progressivement refroidi à température ambiante, est à nouveau rendu acide par ajout de 3mL d'une solution aqueuse de HCl 1 N. Le sol obtenu est à nouveau dilué avec une solution aqueuse de HCl 0,01 N, soit d'un facteur 2 soit d'un facteur 6 pour moduler l'épaisseur de la couche finale. Des nanoparticules de TiO₂ sont ensuite ajoutées de manière à obtenir un rapport molaire Ti/Si de 0,01 pour les sols dilués d'un facteur 6 et de 0,05 pour les sols dilués d'un facteur 2.

Le sol ainsi obtenu est déposé sur le substrat déjà revêtu de sa première couche par une technique de spin coating de manière à obtenir une seconde couche présentant une activité photocatalytique.

Les échantillons sont séchés pendant 10 minutes à 150°C plutôt qu'à température ambiante afin d'assurer une adhésion et une résistance à la rayure optimales.

Tous les échantillons présentent une adhésion satisfaisante au sens de la norme NF ISO 9211-4. La résistance à l'abrasion est également très bonne. Après deux mois d'exposition en plein air, les échantillons traités (revêtus seulement de la couche de silice ou des deux couches) ont un aspect parfaitement propre, tandis que les échantillons témoins non traités sont recouverts de salissures.

## Revendications

1. Procédé d'obtention d'un matériau comprenant un substrat dont au moins une partie de la surface d'au moins une de ses faces est à base de composés organiques, ledit procédé étant mis en oeuvre à pression atmosphérique et sans chauffage de la totalité dudit substrat, ledit procédé comprenant en outre les étapes suivantes :
- on crée à proximité immédiate dudit substrat une zone contenant des espèces actives d'un plasma non thermique,
- on injecte dans ladite zone au moins un précurseur d'un élément chimique de manière à déposer sur au moins une face dudit substrat dont au moins une partie de la surface est à base de composés organiques une première couche mince susceptible de protéger ledit substrat contre des réactions d'oxydation, notamment radicalaire.

2. Procédé selon la revendication 1, tel que les espèces actives du plasma non thermique sont générées à proximité immédiate du substrat en positionnant ledit substrat entre deux électrodes ou sont générées dans une enceinte à l'aide d'un champ électrique puis soufflées à l'extérieur de ladite enceinte en direction dudit substrat.

3. Procédé selon l'une des revendications précédentes, tel que le gaz plasmagène est à base de gaz inerte tel que l'hélium, le néon, l'argon ou l'azote, ou d'un mélange de gaz inertes.

4. Procédé selon la revendication précédente, tel que le gaz plasmagène contient également, de manière minoritaire, un gaz oxydant tel que l'oxygène ou le protoxyde d'azote.

5. Procédé selon l'une des revendications précédentes, tel que le ou chaque précurseur est sous forme gazeuse ou liquide.

6. Procédé selon l'une des revendications précédentes, tel que la première couche mince comprend du silicium et de l'oxygène, notamment est à base d'oxyde de silicium.

7. Procédé selon la revendication précédente, tel que la première couche mince est une couche hybride organique/inorganique comprenant du silicium, de l'oxygène et des espèces carbonées liées de manière covalente au silicium, la teneur en espèces carbonées décroissant éventuellement linéairement dans l'épaisseur de ladite couche mince depuis la zone la plus proche du substrat jusqu'à la surface du matériau.

8. Procédé selon l'une des revendications précédentes, tel que l'épaisseur de la première couche mince est comprise entre 1 nm et 1 micromètre, notamment entre 5 et 50 nm.

9. Procédé selon l'une des revendications précédentes, tel que l'on dépose sur la première couche mince une seconde couche mince à propriété photocatalytique.

10. Procédé selon la revendication précédente, tel que la couche mince à propriété photocatalytique comprend de l'oxyde de titane au moins partiellement cristallisé sous forme anatase.

11. Procédé selon la revendication précédente, tel que l'oxyde de titane est présent sous forme de nanoparticules réparties dans un liant inorganique.

12. Procédé selon la revendication précédente, tel que le liant inorganique est à base d'oxyde de silicium.

13. Procédé selon la revendication précédente, tel que le liant à base d'oxyde de silicium est obtenu par un procédé sol-gel.

14. Procédé selon l'une des revendications 9 à 11, tel que la seconde couche mince à propriété photocatalytique est obtenue en injectant dans la zone contenant les espèces actives du plasma non thermique au moins un précurseur gazeux ou liquide de titane ou des nanoparticules d'oxyde de titane.

15. Procédé selon l'une des revendications précédentes, tel que la surface du substrat ou du matériau est soumise à l'action d'espèces actives du plasma non thermique avant le dépôt de la première couche mince et/ou avant le dépôt de la seconde couche mince et/ou après le dépôt de la seconde couche mince.

16. Procédé selon l'une des revendications précédentes, tel que le substrat est choisi parmi les substrats en polychlorure de vinyle (PVC), en polyéthylène, en polypropylène, en bois peint ou en aluminium peint.

17. Matériau susceptible d'être obtenu par le procédé selon l'une des revendications précédentes.

18. Élément architectural tel que fenêtre, volet, mur ou portail, comprenant un matériau selon la revendication précédente.

19. Utilisation du matériau selon la revendication 17 en tant que matériau auto-nettoyant et/ou susceptible de ne pas se salir et/ou d'être aisément nettoyé.
